# EUROPEAN PATENT APPLICATION

(11) **EP 1 981 135 A2**
(43) Date of publication of application: **15.10.2008**
(21) Application number: 08103064.5
(22) Date of filing: 28.03.2008
(51) Int. Cl.: H01S 5/00, H01S 5/022, H01S 5/068, H04B 10/24, H04B 10/155

(54) **Optical communication module and output control method of semiconductor laser**

(30) Priority: 29.03.2007 JP 2007086650
(71) Applicant: NEC CORPORATION, Tokyo (JP)
(72) Inventor: Oguro, Mamoru, Tokyo (JP)
(74) Representative: Betten & Resch

(57) **Abstract**

An optical communication module includes a semiconductor laser drive circuit configured to supply a drive current to a semiconductor laser so as to output a laser beam; a drive control section configured to control the semiconductor laser drive circuit based on an ambient temperature of the semiconductor laser such that the output light beam has a predetermined light level, and the drive current falls within a predetermined range. A light quantity adjusting section removes a part of the laser beam to produce an output light beam from a remaining portion of the laser beam when the laser beam passes through the light quantity adjusting section, and a quantity of the removed apart of the laser beam depends on a wavelength of the laser beam and an ambient temperature of the semiconductor laser.

## Description

### Technical Field

The present invention relates to an optical communication module and a semiconductor laser output controlling method and, more particularly, to an optical communication module and a semiconductor laser output controlling method, in which an optical circuit of an optical waveguide type is used in optical communications.

### Background Art

Optical communications have been conventionally applied to a so-called backbone network. However, in recent years, the scope of application of the optical communications has been rapidly widened to a subscriber network, which extends from the backbone network and is connected to usage environment of a user, as referred to as FTTH (fiber to the home). Furthermore, a technical development relating to the optical communications has been performed in products under an assumption of an application to the subscriber network.

An optical communication module used in the subscriber network generally requires a smaller size and a lower cost than those in the backbone network. Therefore, an optical transmitting/receiving module having an optical waveguide and transmitting and receiving functions integrated is used mainly as an optical communication module.

In conjunction with the above description, the optical transmitting/receiving module having the transmitting and receiving functions integrated is disclosed in Japanese Patent application Publication (JP-A-Heisei 4-306603). In this technique, miniaturization of the module is achieved by integrating an optical waveguide circuit chip with a light receiving/emitting device.

In the meantime, the light emitting efficiency of a semiconductor laser (hereinafter, to be simply referred to as "an LD") is featured by a decrease at a high temperature while an increase at a low temperature. In view of this, a LD driving technique has been known in which a drive current of the LD is increased at the high temperature and decreased at the low temperature, so that an optical communication module can be driven in a constant fiber optical output state. A technique for simplifying a circuit configuration in the LD driving technique is disclosed in Japanese Patent Application Publication (JP-A-Heisei 3-9587).

In actual use, an upper limit of a drive current Iop of the LD device is restricted by a drive capacity of an LD drive circuit. In contrast, a lower limit of the drive current is restricted by relaxation oscillation frequency required for meeting a pulse mask definition. If lop is lower than a lower limit, it is impossible to meet the pulse mask definition.
As a consequence, an optical transmitting module requires a narrow range of the drive current Iop for a wide temperature region.

As described above, a device such as an optical transceiver for use in the subscriber network is required to be fabricated at a tight cost. An optical module need be essentially fabricated at a high yield for the purpose of cost reduction. An optical transmitting module of a well-known type using an optical waveguide requires a narrow range of a drive current for a wide temperature region, as described above. Therefore, it is necessary to suppress a variation in optical loss on an optical path until a light beam emitted from the LD device is emitted from an optical fiber. However, the above-described techniques have not been developed under an assumption of the solution of such a problem. In addition, there have remained yet an increase in fabrication yield, an increase in production efficiency and a decrease in cost.

### Summary

Therefore, an object of the present invention is to provide an optical communication module in which an allowable value of a variation in optical loss on an optical path is widened until a light beam emitted from an LD device is emitted from an optical fiber.

In an exemplary embodiment of the present invention, an optical communication module includes a semiconductor laser drive circuit configured to supply a drive current to a semiconductor laser so as to output a laser beam; a drive control section configured to control the semiconductor laser drive circuit based on an ambient temperature of the semiconductor laser such that the output light beam has a predetermined light level, and the drive current falls within a predetermined range. A light quantity adjusting section removes a part of the laser beam to produce an output light beam from a remaining portion of the laser beam when the laser beam passes through the light quantity adjusting section, and a quantity of the removed apart of the laser beam depends on a wavelength of the laser beam and an ambient temperature of the semiconductor laser.

In another exemplary embodiment of the present invention, an output control method of a laser beam, includes controlling a drive current based on an ambient temperature of a semiconductor laser such that an output light beam has a predetermined light level, and the drive current falls within a predetermined range; driving the semiconductor laser with the drive current to output a laser beam; removing a part of the laser beam to produce the output light beam from a remaining portion of the laser beam, wherein a quantity of the removed apart of the laser beam depends on a wavelength of the laser beam and an ambient temperature of the semiconductor laser.

### Brief Description of the Drawings

The above and other objects, advantages and features of the present invention will be more apparent from the following description of certain exemplary embodiments taken in conjunction with the accompanying drawings, in which:
FIG. 1 is a conceptual diagram schematically illustrating a configuration of an optical transmitting/receiving module including a PLC chip according to a first exemplary embodiment of the present invention;
FIG. 2 is a conceptual diagram illustrating a structure of a directional coupler in FIG. 1;
FIG. 3 is a functional block diagram illustrating a drive current control section in FIG. 1;
FIG. 4 is a graph illustrating one example of a coupling loss Pc/Pin to the wavelength of a light beam emitted from an LD device in the directional coupler;
FIG. 5 is a graph illustrating one example of oscillation wavelength of the LD device and coupling loss Pc/Pin in the directional coupler to an ambient temperature;
FIG. 6 is a diagram schematically illustrating a relationship between a drive current Iop and an optical output P of an LD device at three ambient temperatures of a low temperature T1, a room temperature T2 and a high temperature T3;
FIG. 7 is a graph illustrating a relationship between an ambient temperature and drive current lop of the LD device in case of a configuration with the directional coupler in the first exemplary embodiment and in case of a configuration without any directional coupler; and
FIG. 8 is a conceptual diagram schematically illustrating a configuration of an optical transmitting module according to a second exemplary embodiment of the present invention.

### Exemplary Embodiments

Hereinafter, an optical transmitting /receiving module according to exemplary embodiments of the present invention will be described in detail with reference to the attached drawings. In the following description, an optically directional coupler is provided on an optical waveguide on a side of an laser diode (LD) light input port on a planar light wave circuit (hereinafter, to be simply abbreviated as "a PLC") to branch an light beam emitted from an LD is branched, so that a drive current Iop of an optical communication module can be controlled in a region, in which a pulse mask standard is satisfied, in an operating temperature limit. It should be noted that although an optical transmitting/receiving module having a transmitting/receiving function exemplifies the optical communication module, an optical transmitting module having only a transmitting function may exemplify it.

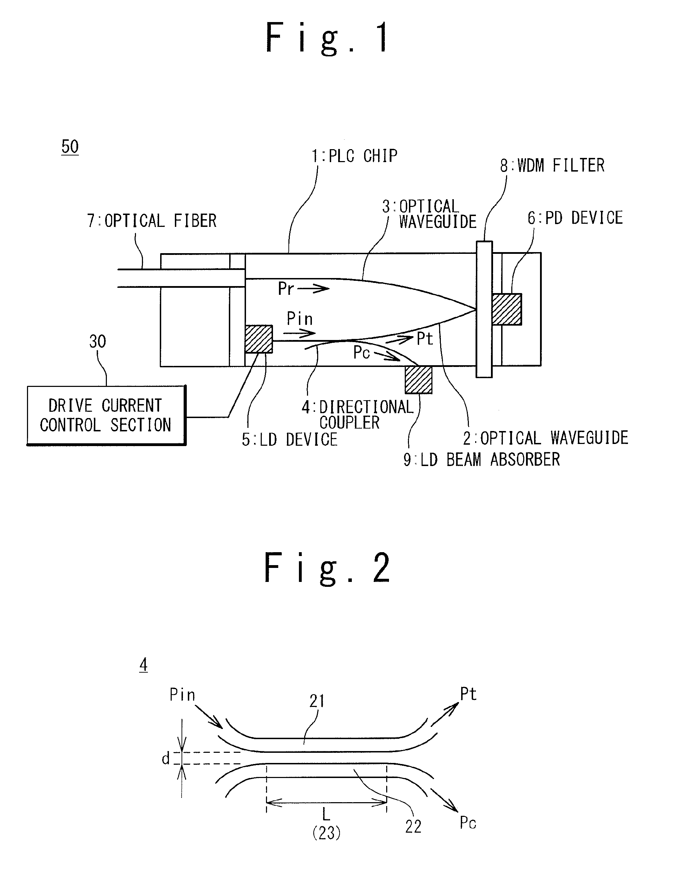

FIG. 1 is a conceptual diagram schematically illustrating a configuration of an optical transmitting/receiving module 50 including a PLC chip 1 according to a first exemplary embodiment of the present invention. First and second optical waveguides 2 and 3 are formed on the PLC chip 1, and a directional coupler 4 is provided on the first optical waveguide 2. A PLC circuit is a quartz glass optical waveguide which is fabricated on a silicon substrate by using an optical fiber fabricating technique and a semiconductor fine machining technique.

An LD mounting section, a receiving photodiode (PD) mounting section and a fiber mounting section are disposed on the PLC chip 1 and an LD device 5, a PD device 6 and an optical fiber 7 are mounted on them, respectively. Moreover, a wavelength division multiplexing (to be abbreviated as "WDM") filter 8 is stuck at an intersection of the first optical waveguide 2 and the second optical waveguide 3. Furthermore, an LD optical absorber 9 is disposed at an end of the directional coupler 4. The LD device 5, the PD device 6, the optical fiber 7, the WDM filter 8 and the LD optical absorber 9 may be generally used in an optical communication module. Additionally, the optical transmitting/receiving module 50 includes a drive current control section 30 for controlling the drive of the LD device 5.

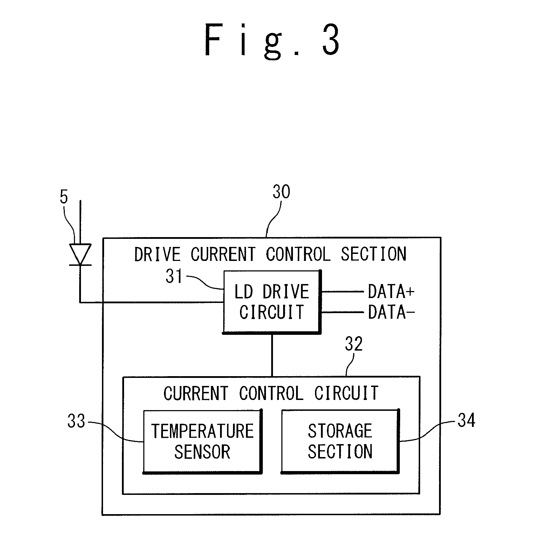

FIG. 3 is a functional block diagram illustrating the drive current control section 30. The drive current control section 30 includes an LD drive circuit 31 for driving the LD device 5, and a current control circuit 32 for controlling a drive current to be supplied to the LD device 5. The drive current is controlled by a feed/forward automatic power control (APC) system. In addition, the current control circuit 32 includes a temperature sensor 33 for measuring an ambient temperature and a storage section 34 for recording therein a relationship of drive current (i.e., a bias current and a modulation current) and ambient temperature.

Returning to FIG. 1, a transmission light beam Pin as a light beam emitted from the LD device 5 is coupled to the first optical waveguide 2, and then is propagated in of the first optical waveguide 2. During the propagation in the first optical waveguide 2, the transmission light beam Pin passes through the directional coupler 4. At this time, the transmission light beam Pin is branched into a passing light beam Pt and a branched light beam Pc. The passing light beam Pt is propagated to the WDM filter 8. The passing light beam Pt is fully reflected on the WDM filter 8, and then is propagated from the second optical waveguide 3 to an optical transmission channel through the optical fiber 7.

In the meantime, the branched light beam Pc is turned to be a stray light beam in the optical transmitting/receiving module 50, thereby possibly causing degradation of a receiver sensitivity when it is diffracted to the receiving PD device 6. In view of this, the branched light beam Pc is absorbed by the LD optical absorber 9.

In contrast, a received light beam Pr different in wavelength from the transmission light beam Pin is propagated in the second optical waveguide 3 from the optical transmission channel through the optical fiber 7, passes through the WDM filter 8, and then is received by the PD device 6. In other words, the WDM filter 8 reflects a light beam having a same wavelength as that of the transmission light beam Pin (i.e., the passing light beam Pt), whereas allowing a light beam having a same wavelength as that of the received light beam Pr to pass therethrough.

FIG. 2 is a conceptual diagram illustrating a structure of the directional coupler 4. In the directional coupler 4, the transmission light beam Pin supplied to a waveguide 21 for the passing light beam is branched in a proximal extension section 23, into the passing light beam Pt propagated in the waveguide 21 as it is and the branched light beam Pc propagated in a waveguide 22. Here, a branch ratio of the passing light beam Pt to the branched light beam Pc is controlled based on a coupling length L of the proximal extension section 23 and an inter-waveguide distance d between the waveguide 21 and the waveguide 22 in the proximal extension section 23. The branch ratio of the directional coupler 4 has a wavelength dependency. That is to say, the branch ratio of the passing light beam Pt to the branched light beam Pc is varied in accordance with an oscillation wavelength of the LD device 5 and an ambient temperature around the LD device 5. Even if the above-described coupling length L and inter-waveguide distance d are set to desired values, the branch ratio of the passing light beam Pt to the branched light beam Pc is varied due to the characteristics of the directional coupler 4 when the ambient temperature of the LD device 5 varies. Additionally, the LD device 5 has the characteristics in which an oscillation wavelength shifts linearly when the ambient temperature is varied. If the oscillation wavelength is shifted, the branch ratio of the passing light beam Pt to the branched light beam Pc is varied in the directional coupler 4. As a consequence, the branch ratio of the directional coupler 4 is optimized in accordance with wavelength/temperature characteristics of the LD device 5 to be used, so that the branched light beam Pc can be intensified at a specified temperature.

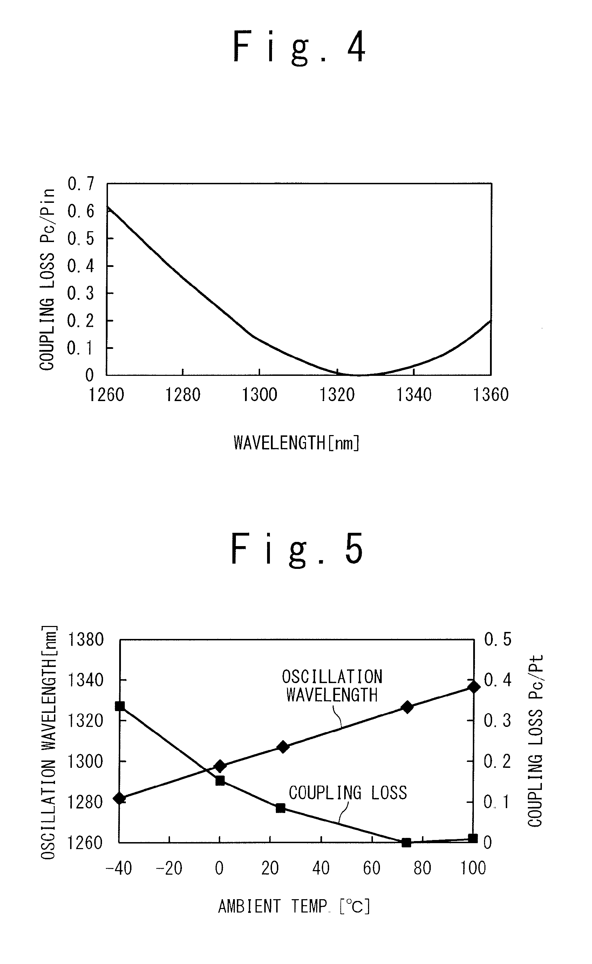

FIG. 4 is a graph illustrating one example of a coupling loss Pc/Pin to the wavelength of a light beam emitted from an LD device in the directional coupler 4. The coupling loss Pc/Pin is 0 near the wavelength of 1325 nm according to the coupling loss Pc/Pin curve in the directional coupler 4. As the wavelength is moved away from 1325 nm, the coupling loss Pc/Pin is increased. For example, when the wavelength is near 1300 nm, the coupling loss Pc/Pin is about 0.13. In other words, about 13% of the transmission light beam Pin is the branched light beam Pc, and therefore the passing light beam Pt led to the optical fiber 7 is about 87% of the transmission light beam Pin. Otherwise, when the wavelength is 1340 nm, the coupling loss Pc/Pin is about 0.03.

FIG. 5 is a graph illustrating one example of oscillation wavelength of the LD device 5 and coupling loss Pc/Pin in the directional coupler 4 to an ambient temperature. The oscillation wavelength of the LD device 5 is linearly increased as the ambient temperature is increased. For example, the LD device 5 having the oscillation wavelength of about 1300 nm at the ambient temperature of 0 °C has the oscillation wavelength of about 1325 nm at 75 °C. The coupling loss Pc/Pin is almost 0 at the ambient temperature of about 75 °C or higher. In other words, substantially 100% of the transmission light beam Pin is the passing light beam Pt. As the ambient temperature becomes lower than 75 °C, the coupling loss Pc/Pin is increased. When the ambient temperature is 20 °C, the coupling loss Pc/Pin is about 0.09, and when the ambient temperature is 0 °C, the coupling loss Pc/Pin is about 0.15.

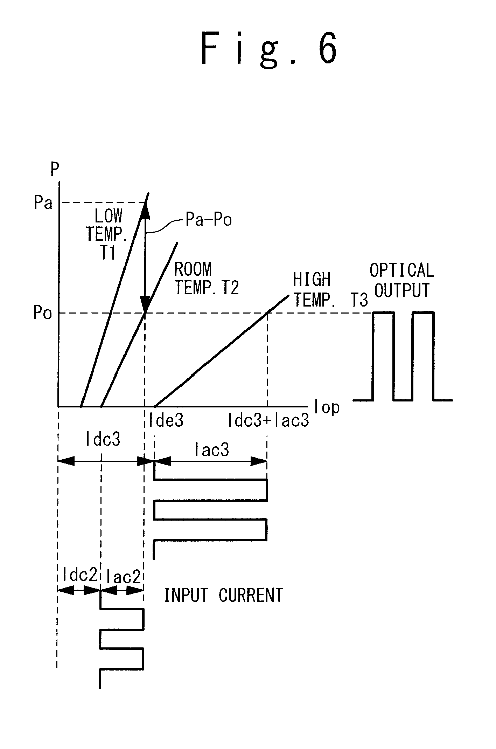

Here, description will be given below on the relationship between a drive current and an optical output from the LD device 5. FIG. 6 is a diagram schematically illustrating the relationship between a drive current Iop and an optical output P of the LD device 5 at three ambient temperatures of a low temperature T1, a room temperature T2 and a high temperature T3. As illustrated in FIG. 6, as the ambient temperature becomes lower, the required drive current Iop becomes smaller. The drive current lop is classified into a bias current Idc having an optical output P of just 0 and a modulation current Iac for use in outputting an amplitude of a signal. That is to say, the drive current lop for outputting a desired optical output Po is equal to a summation of the bias current Idc and the modulation current Iac, i.e., the bias current Idc + the modulation current Iac. For example, in case of the high temperature T3, the bias current is Idc3 whereas the modulation current is Iac3, and a drive current Iop for outputting the target output Po becomes Idc3 + Iac3. In the same manner, in case of the room temperature T2, the bias current is Idc2 whereas the modulation current is Iac2, and the drive current Iop for outputting the optical output Po becomes Idc2 + Iac2.

In order to achieve a signal form (i.e., a pulse form) during optical communications, a pulse waveform of the drive current Iop need meet a predetermined form, that is, a pulse mask definition. For this purpose, the modulation current Iac need be a predetermined value or greater. For example, it is assumed that a lower limit of the modulation current Iac is set to Iac2 whereas a lower limit of the bias current is set to Idc2. When the ambient temperature is decreased to the low temperature T1, a slope efficiency is improved. The optical output P exceeds the target optical output Po and becomes an output Pa in case of the above-described modulation current Iac2 and bias current Idc2. Consequently, the directional coupler 4 branches the branched light beam Pc for a quantity (Pa - Po) in excess of the target output Po, and then sets an output of the passing light beam Pt transmitted from the optical fiber 7 to the target output Po.

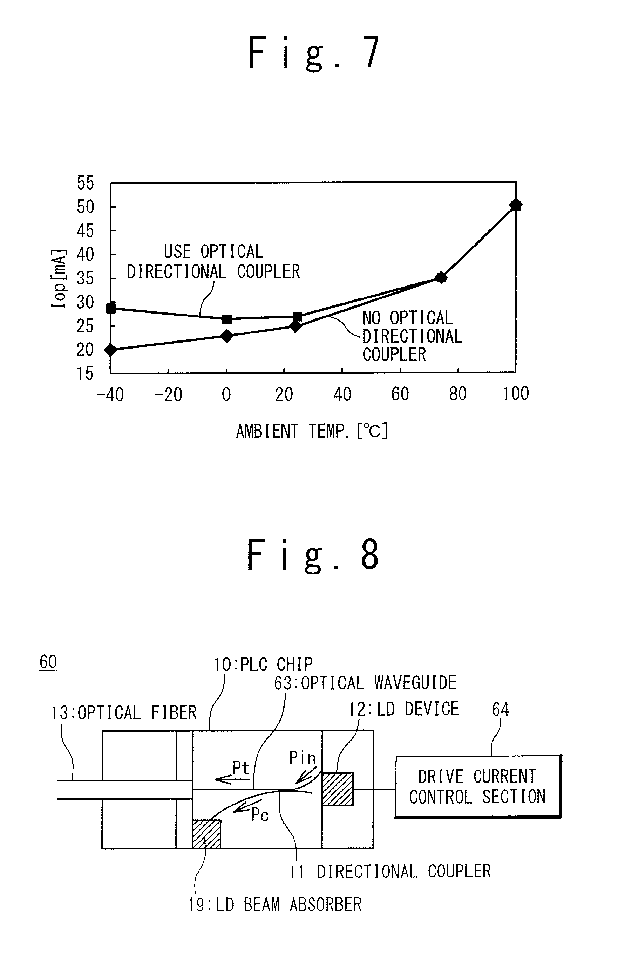

Moreover, the directional coupler 4 has the coupling loss Pc/Pin characteristics illustrated in FIG. 4 or FIG. 5, and therefore it produces the branched light beam Pc except for specified conditions. In view of this, the LD device need be oscillated with a drive current Iop (the bias current Idc and the modulation current Iac) according to the ambient temperature in such a manner that an output of the passing light beam Pt transmitted from the directional coupler 4 becomes the target output Po. Therefore, the relationship between the ambient temperature and the drive current Iop (the bias current Idc and the modulation current Iac), as illustrated in FIG. 7, is stored in the storage section 34 in the current control circuit 32. In this way, the current control circuit 32 reads from the storage section 34, the drive current Iop (the bias current Idc and the modulation current Iac) based on the ambient temperature detected by the temperature sensor 33, and controls the LD drive circuit 31 to supply the drive current Iop to the LD device 5.

FIG. 7 is a graph illustrating a relationship between the ambient temperature and the drive current Iop of the LD device 5 in a configuration provided with the directional coupler 4 in the present exemplary embodiment and a configuration in the related art without any directional coupler 4. Since the configuration in the related art includes no directional coupler 4, the drive current Iop at each of the temperatures need be adjusted based on only the temperature characteristics of the slope efficiency of the LD device 5. As a result, in case of the decrease in the ambient temperature, the drive current lop need be decreased as the slope efficiency is more improved. Therefore, the drive current lop may be possibly lower than a level (i.e., a lower limit level) at which the pulse mask definition can be met. For example, if the lower level of the drive current Iop is 25 mA, a proper LD output capable of meeting the pulse mask definition can be achieved at the ambient temperature of almost 25 °C in the related art configuration.

In contrast, in the configuration in the present exemplary embodiment, the output is adjusted also in the directional coupler 4 even in case of the use of the same LD device 5, and therefore, a decrease width can be smaller than in the related art configuration even if the drive current lop need be decreased since a slope efficiency is more improved or enhanced as the ambient temperature becomes lower. As a result, even when the drive current Iop is lower than the lower level in the related art configuration, the drive current Iop is not lower than the lower level or even at a lower ambient temperature in the present exemplary embodiment. For example, as described above, if the lower level is 25 mA, the lowest value is about 27 mA at the ambient temperature of 0 °C in the present exemplary embodiment. The drive current Iop cannot become lower than the lower limit level at the ambient temperatures within the entire range from -40 °C to 100 °C, as illustrated, with a configuration in the present exemplary embodiment.

Otherwise, if the lower level of the drive current Iop is 20 mA, the proper LD output can be achieved within the entire range of the ambient temperature even in the related art configuration. However, even in that case, a margin to the lower limit level can be widened by shifting the drive current Iop in such a manner as to increase it, like in the present exemplary embodiment. Namely, an allowable error range is widened, thus enhancing a fabrication yield of an optical transmitting /receiving module 50. In other words, it is possible to prevent any decrease in drive current lop on a lower temperature, to control the drive current lop in a region in which the pulse mask definition can be met, and to widen an allowable value to a lower limit so as to meet the pulse mask definition by designing the optical transmitting/receiving module 50 in such a manner as to more increase the coupling loss Pc/Pin as the ambient temperature is more decreased, in comparison with the related art configuration without any directional coupler 4. In contrast, it is possible to prevent the drive current Iop from being increased in excess of a predetermined value by designing the optical transmitting/receiving module 50 such that the branched light beam Pc ≈ 0 on a side of a higher temperature in such a manner as not to exceed an upper limit level of drive capacity of the LD drive circuit 31.

The present invention has been described above with reference to the exemplary embodiments. However, the present invention is not limited to the above-described exemplary embodiment. Therefore, it is to be understood that the present invention can be variously modified within a range without departing from the scope of the present invention. For example, FIG. 8 is a conceptual diagram schematically illustrating a configuration of an optical transmitting module 60 which is achieved by omitting the receiving function from the above-described optical transmitting/receiving module 50. An optical waveguide 63 is formed on a PLC chip 10 in the optical transmitting module 60, and further a directional coupler 11 is mounted on the optical waveguide 63. On the PLC chip 10 are disposed an LD mounting section and a fiber mounting section, and an LD device 12 and an optical fiber 13 are mounted on their sections, respectively. Furthermore, an LD optical absorber 19 is disposed at the end of the directional coupler 11. The LD device 12 is connected to a drive current control section 64 having the same arrangement and function as those in the above-described exemplary embodiment. Thus, the present invention is widely applicable to the optical transmitting/receiving module or the optical transmitting module for use in the optical communications.

According to the present invention, it can achieve an optical communication module having the wide range of the allowable value of the variations in optical loss until the light beam emitted from the LD is emitted from the optical fiber, thus enhancing a fabrication yield and reducing the cost in the optical communication module.

While the present invention has been particularly shown and described with reference to the exemplary embodiments thereof, the present invention is not limited to these exemplary embodiments. It will be understood by those of ordinary skill in the art that various changes in form and details may be made therein without departing from the spirit and scope of the present invention as defined by the claims.

## Claims

1. An optical communication module comprising:
a semiconductor laser drive circuit configured to supply a drive current to a semiconductor laser so as to output a laser beam;
a light quantity adjusting section configured to remove a part of the laser beam to produce an output light beam from a remaining portion of the laser beam when the laser beam passes through said light quantity adjusting section, wherein a quantity of the removed apart of the laser beam depends on a wavelength of the laser beam and an ambient temperature of said semiconductor laser; and
a drive control section configured to control said semiconductor laser drive circuit based on the ambient temperature such that the output light beam has a predetermined light level, and the drive current falls within a predetermined range.

2. The optical communication module according to claim 1, wherein said drive control section controls said semiconductor laser drive circuit such that the removed part is increased more as the ambient temperature becomes lower than a predetermined temperature.

3. The optical communication module according to claim 1 or 2, wherein said drive control section controls said semiconductor laser drive circuit such that the removed part is increased more as the wavelength of the laser beam is deviated more from a predetermined wavelength.

4. The optical communication module according to any of claims 1 to 3, further comprising:
a temperature detecting section configured to detect the ambient temperature of said semiconductor laser.

5. The optical communication module according to claim 4, further comprising:
a storage section configured to store a relation of drive current to ambient temperature,
wherein said drive control section controls said semiconductor laser drive circuit to supply the drive current corresponding to the detected ambient temperature to said semiconductor laser.

6. The optical communication module according to any of claims 1 to 5, wherein said light quantity adjusting section comprises:
an optical directional coupler configured to branch the part of the laser beam from said semiconductor laser to remove the part of the laser beam.

7. The optical communication module according to any of claims 1 to 6, further comprising:
a light absorber configured to absorb the removed part of the laser beam from said.

8. An output control method of a laser beam, comprising:
controlling a drive current based on an ambient temperature of a semiconductor laser such that an output light beam has a predetermined light level, and the drive current falls within a predetermined range;
driving said semiconductor laser with the drive current to output a laser beam; and
removing a part of the laser beam to produce the output light beam from a remaining portion of the laser beam, wherein a quantity of the removed apart of the laser beam depends on a wavelength of the laser beam and an ambient temperature of said semiconductor laser.

9. The output control method according to claim 8, wherein said controlling comprises:
controlling the drive current such that the removed part is increased more as the ambient temperature becomes lower than a predetermined temperature.

10. The output control method according to claim 8 or 9, wherein said removing comprises:
branching the part of the laser beam from said semiconductor laser to remove the part of the laser beam.
